# EUROPÄISCHE PATENTSCHRIFT

(11) **EP 2 986 752 B1**
(45) Veröffentlichungstag und Bekanntmachung des Hinweises auf die Patenterteilung: **07.04.2021**
(21) Anmeldenummer: 14722542.9
(22) Anmeldetag: 14.04.2014
(51) Int. Cl.: C23C 14/06, C23C 14/08, C23C 14/32, C23C 28/04, C23C 28/00, C23C 14/34

(54) **OXIDATIONSSCHUTZSCHICHT AUF CHROMBASIS**
CHROMIUM-BASED OXIDATION PROTECTION LAYER
COUCHE DE PROTECTION CONTRE L'OXYDATION À BASE DE CHROME

(30) Priorität: 16.04.2013 US 201361812350 P
(43) Veröffentlichungstag der Anmeldung: 24.02.2016
(73) Patentinhaber: Oerlikon Surface Solutions AG, Pfäffikon, 8808 Pfäffikon SZ (CH)
(72) Erfinder: RAMM, Juergen, CH-7304 Maienfeld (CH)
(74) Vertreter: Misselhorn, Hein-Martin
(86) Internationale Anmeldenummer: PCT/EP2014/000991
(87) Internationale Veröffentlichungsnummer: WO 2014/170005

(56) Entgegenhaltungen:
- EP-A1- 2 037 004
- EP-A1- 2 037 004
- EP-A1- 2 279 837
- EP-A1- 2 279 837
- WO-A1-99/23277
- WO-A1-2006/099754
- WO-A1-2006/099754
- WO-A1-2008/043606
- WO-A1-2008/043606

## Beschreibung

Die vorliegende Erfindung betrifft eine Oxidationsschutzschicht auf Chrombasis für Substrate welche hohen Temperaturen ausgesetzt werden.

### Stand der Technik

Gemäss der DE 102005061060 werden Oxidationsschutzschichten beispielsweise bei Gasturbinenteilen, Gasturbinenschaufeln, Platten von Brennkammern oder dergleichen eingesetzt. Dort wird beschrieben wie Schichten mittels sogenannten Plasmaspritzens aus einer Suspension heraus auf die Substrate aufgebracht wird. Solche derart aufgebrachten Schichten haben allerdings u.a. den Nachteil, dass diese nur relativ dick aufgebracht werden können und auch Spannungen aufweisen, welche sich negativ auf das Haftungsvermögen auswirken können. Oxidationsbeständige und schlecht wärmeleitende Werkstoffe werden aber auch im Zusammenhang mit Kolben eingesetzt, wie zum Beispiel in der DE10 2009 035841 offenbart.

Die WO 2008/043606 A1 zeigt ein PVD Schichtsystem zum Beschichten von Werkstücken, welches eine Mischkristallschicht eines Mehrfachoxids umfasst.

Die WO 2006/099754 A1 offenbart eine Hartstoffschicht als oxidische Arc - PVD Funktionsschicht, welche auf einem Werkstück abgeschieden ist. Die Schicht ist im Wesentlichen als elektrisch isolierendes Oxid ausgebildet.

Die EP 2 279 837 A1 zeigt ein alternierendes Schichtsystem auf einem Schneidwerkzeug von Holz. Ähnlich zeigt die EP 2 037 004 A1 ein Schichtsystem auf einem Schneidwerkzeug von Holz. Hohe Temperaturen treten hierbei nicht auf.

Es besteht daher ein Bedürfnis nach Schichten welche für Substrate, die in der Anwendung hohen Temperaturen ausgesetzt sind, einen guten Oxidationsschutz bieten.

### Aufgabe der vorliegenden Erfindung

Es ist daher eine Aufgabe der vorliegenden Erfindung solche Schichten sowie deren Herstellungsverfahren anzugeben.

### Beschreibung der vorliegenden Erfindung

Erfindungsgemäss wird die Aufgabe durch ein Chrom enthaltendes Schichtsystem nach Anspruch 1 gelöst.

Erfindungsgemäß ist das Herstellungsverfahren des Schichtsystems in Anspruch 4 beansprucht. Ein Schichtsystem wird mittel Abscheidung aus der Gasphase aufgebracht. Hierbei kommen beispielsweise PVD und/oder CVD Verfahren in Frage. Es ist auch möglich einen Teil der Schichten des Schichtsystems mittels PVD und den anderen Teil der Schichten des Schichtsystems mittels CVD aufzubringen. Beispielsweise kann als PVD Verfahren das Sputtern und/oder das Verdampfen unter Vakuumbedingungen angewendet werden. Beim Verdampfen ist als besonders bevorzugt das Funkenverdampfen zu nennen, bei dem mittels eines Lichtbogens Material von einer Targetoberfläche lokal verdampft wird.

Es werden mehrere, nur teilweise beanspruchte, Ausführungsformen beispielhaft im Detail beschrieben. Gemäss einer ersten Ausführungsform wird auf ein Substrat eine 3µm dicke CrN Zwischenschicht aufgebracht auf die eine 3µm dicke AlCrO-Schicht aufgebracht wird.

Die AlCrO-Schicht kann auch als Multilayerschicht abgeschieden werden, beispielweise mit unterschiedlichen Zusammensetzungen für die Einzellschichten abgeschieden werden kann.

Gemäss einer zweiten Ausführungsform wird auf ein Substrat eine 3.5 µm dicke CrN Zwischenschicht aufgebracht auf die eine 3.5 µm dicke AlCrO-Schicht aufgebracht wird.

Gemäss einer dritten Ausführungsform wird auf ein Substrat eine 1.7 µm dicke CrN Zwischenschicht aufgebracht auf die eine 1.7 µm dicke AlCrO-Schicht aufgebracht wird.

Gemäss einer vierten Ausführungsform wird auf ein Substrat eine 5 µm dicke CrN Zwischenschicht aufgebracht auf die eine 5 µm dicke CrO/N Multilayer (CrO/CrN Multilayer) aufgebracht wird.

Bei den vorgenannten Ausführungsformen kann die Beschichtungstemperatur beispielsweise bei 450C liegen.

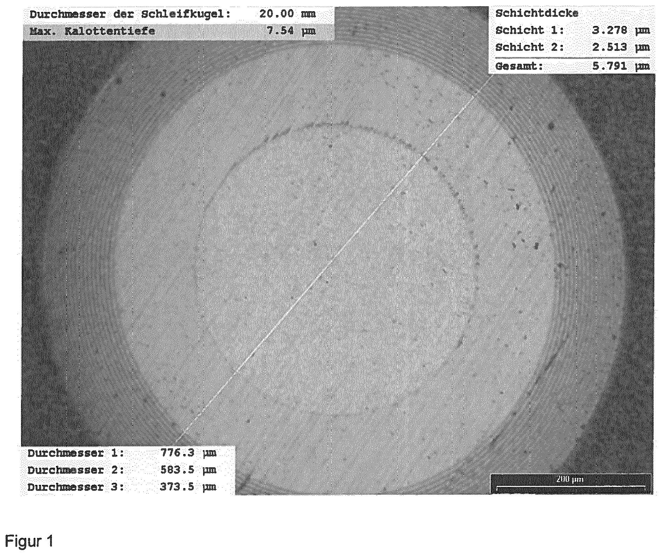

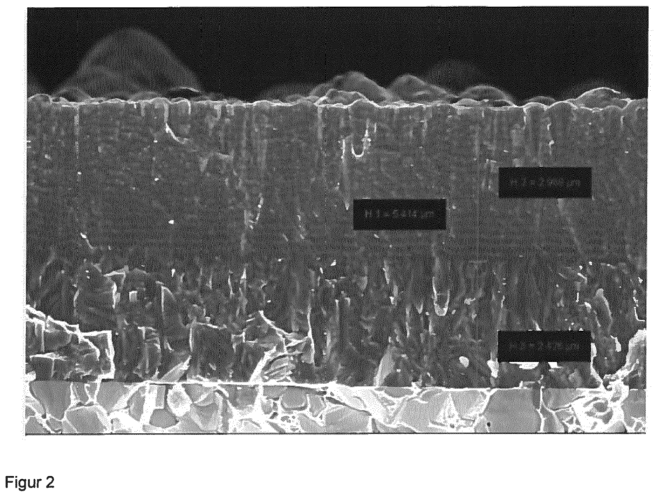

Gemäss einer fünften und bevorzugten Ausführungsform wird auf eine auf das Substrat aufgebachte CrN Zwischenschicht eine CrN/CrON Multischicht aufgebracht (siehe hierzu den Kaloschliff in der Figur 1). Wie aus der Elektronenmikroskopaufnahme der Figur 2 ersichtlich beträgt die Dicke der CrN Zwischenschicht ca. 2.4 µm und die Dicke der Multischicht ca. 3 µm.

Bei der Multischicht handelt es sich im Beispiel um ein aus 36 Einzelschichten bestehendes Multilayer, davon jeweils 18 CrN Einzelschichten und 18 CrON Einzelschichten (siehe Figur 1). Zum Aufbringen der Schichten wurde für jede Einzelschicht jeweils ca. 2 Min benötigt, so dass die Dauer für die Beschichtung der Multischicht in etwa 72 Minuten betrug. Bei der Beschichtung wurde eine Beschichtungstemperatur von ca. 230°C eingehalten.

Dabei kann die Anzahl der Einzelschichten sowie deren Dicke der Anwendung angepasst gewählt werden. Es resultiert eine dünne, hochbeständige und vor Oxidation schützende Schutzschicht, geeignet unter anderem für Substrate welche in der Anwendung hohen Temperaturen ausgesetzt sind und die vor Oxidation geschützt werden sollten.

In den Beispielen wurde CrN als Zwischenschicht. Es ist jedoch auch möglich andere Schichten als Zwischenschichten zu verwenden, so zum Beispiel metallisches Chrom. Es ist auch möglich zunächst metallisches Chrom auf die Substratoberfläche aufzubringen, gefolgt von einer dickeren CrN Schicht auf die dann eine aus dünneren Einzelschichten aufgebaute CrN/CrON Multischicht aufgebracht wird.

Offenbart wurde eine Oxidationsschutzschicht auf Chrombasis für Substrate welche hohen Temperaturen ausgesetzt werden, wobei die Schicht ein Chrom enthaltendes Schichtsystem umfasst welches eine Basisschicht und eine Funktionsschicht umfasst und wobei die Basisschicht sich zwischen dem Substrat und der Funktionsschicht befindet, und wobei die Basisschicht mindestens grösstenteils Chromnitrid enthält und die Funktionsschicht Chromoxid enthält.

Gemäss einer bevorzugten Ausführungsform besteht die Basisschicht aus Chromnitrid, kann aber auch für manche Anwendungen aus Aluminiumchromnitrid bestehen.

Gemäss einer weiteren Ausführungsform enthält die Funktionsschicht mindestens grösstenteils Aluminiumchromoxid oder vorzugsweise besteht die Funktionsschicht aus Aluminiumchromoxid.

Gemäss einer besonders bevorzugten Ausführungsform weist die Funktionsschicht eine mehrlagige Schichtstruktur auf welche alternierend-abgeschiedene Einzelschichten A und B umfasst, wobei die Zusammensetzung der A Einzelschichten sich von der Zusammensetzung der B Einzelschichten unterscheidet.

Die Schichtdicke der Basisschicht ist vorzugsweise grösser 1 µm, für manche Anwendung vorzugsweise zwischen 1,5 und 10 µm ist oder noch mehr bevorzugt zwischen 2 µm und 7 µm ist.

Das Verhältnis zwischen der Schichtdicke der Funktionsschicht und der Schichtdicke der Basisschicht liegt vorzugsweise zwischen 0.5 und 2, oder für manche Anwendungen vorzugsweise zwischen 0.25 und 1.5.

Auch ist eine Oxidationsschutzschicht auf Chrombasis für Substrate welche hohen Temperaturen ausgesetzt werden, wobei die Schicht ein Chrom enthaltendes Schichtsystem umfasst welches eine Funktionsschicht umfasst, und wobei die Funktionsschicht eine mehrlagige Schichtstruktur aufweist welche alternierend-abgeschiedene Einzelschichten A und B umfasst, wobei die Zusammensetzung der A Einzelschichten sich von der Zusammensetzung der B Einzelschichten unterscheidet, und wobei die A Einzelschichten mindestens grösstenteils Aluminiumchromnitrid oder vorzugsweise Chromnitrid und die B Einzelschichten mindestens grösstenteils Aluminiumchromoxid oder Chromoxid oder vorzugsweise Aluminiumchromoxinitrid oder noch mehr bevorzugt Chromoxinitrid enthalten.

Im Allgemeinen, enthalten die A Einzelschichten mindestens grösstenteils Aluminiumchromnitrid oder vorzugsweise Chromnitrid und die B Einzelschichten mindestens grösstenteils Aluminiumchromoxid oder Chromoxid oder vorzugsweise Aluminiumchromoxinitrid oder noch mehr bevorzugt Chromoxinitrid.

Gemäss weiteren bevorzugten Ausführungsformen einer Oxidationsschicht
- Bestehen die A Einzelschichten aus Aluminiumchromnitrid und die B Einzelschichten aus Aluminiumchromoxid oder vorzugsweise aus Aluminiumchromoxinitrid, oder
- Bestehen die A Einzelschichten aus Chromnitrid und die B Einzelschichten aus Aluminiumchromoxid oder vorzugsweise aus Aluminiumchromoxinitrid, oder besonders bevorzugt
- Bestehen die A Einzelschichten aus Chromnitrid und die B Einzelschichten aus Chromoxid oder vorzugsweise aus Chromoxinitrid.

Die mehrlagige Schichtstruktur kann auch eine Einzelschicht C umfassen welche zwischen einer A Einzelschicht und einer B Einzelschicht abgeschieden ist, wobei die Zusammensetzung der C Einzelschicht sich jeweils von der Zusammensetzung der A Einzelschicht und von der Zusammensetzung der B Einzelschicht unterscheidet, und wobei die C Einzelschicht mindestens grösstenteils Aluminiumchromoxinitrid oder vorzugsweise Chromoxinitrid enthält.

Vorzugsweise besteht eine solche C Einzelschicht aus Aluminiumchromoxinitrid oder noch bevorzugt aus Chromoxinitrid.

Gemäss einer bevorzugten Ausführungsform umfasst die mehrlagige Schichtstruktur, jeweils zwischen jeder Einzelschicht A und jeder Einzelschicht B welche eine auf der anderen alternierend-abgeschieden sind, eine Einzelschicht C, deren Stickstoff-Anteil grösser als der Stickstoffanteil in der direkt nebenstehenden Einzelschicht B und kleiner als der Stickstoffanteil in der direkt nebenstehenden Einzelschicht A ist.

Die Schichtdicke jeder Einzelschicht A und/oder B beträgt vorzugsweise zwischen 50 nm und 100 nm.

Zudem wurde auch ein beschichtetes Substrat mit einer Oxidationsschicht gemäss einer der oben beschriebenen Ausführungsformen offenbart.

Ausserdem wurde ein Verfahren zur Herstellung einer Oxidationsschicht nach der oben beschriebenen Ausführungsformen offenbart, wobei vorzugsweise das Verfahren ein PVD-Verfahren ist, beispielweise ein Sputterverfahren oder für manche Anwendungen vorzugsweise ein Funkenverdampfungsverfahren. Vorzugsweise sollte die Prozesstemperatur während des Beschichtungsprozesses nicht höher als 450 °C sein.

## Patentansprüche

1. Oxidationsschutzschicht auf Chrombasis für Substrate, welche hohen Temperaturen ausgesetzt werden, wobei die Schicht auf Chrombasis mittels PVD und/oder CVD auf einem Substrat aufgebracht ist und ein Chrom enthaltendes Schichtsystem umfasst, welches eine Basisschicht und eine Funktionsschicht umfasst, wobei die Basisschicht sich zwischen dem Substrat und der Funktionsschicht befindet, wobei die Funktionsschicht Chromoxid enthält, wobei die Funktionsschicht eine mehrlagige Schichtstruktur aufweist, welche alternierend-abgeschiedene Einzelschichten A und B umfasst, wobei die Zusammensetzung der A Einzelschichten sich von der Zusammensetzung der B Einzelschichten unterscheidet, wobei die Basisschicht aus Chromnitrid besteht, und wobei die A Einzelschichten aus Chromnitrid und die B Einzelschichten aus Chromoxid oder Chromoxinitrid bestehen,
**dadurch gekennzeichnet, dass** die mehrlagige Schichtstruktur jeweils zwischen jeder Einzelschicht A und jeder Einzelschicht B, welche eine auf der anderen alternierend-abgeschieden sind, eine Einzelschicht C umfasst, deren Stickstoff-Anteil grösser als der Stickstoffanteil in der direkt nebenstehenden Einzelschicht B und kleiner als der Stickstoffanteil in der direkt nebenstehenden Einzelschicht A ist.

2. Oxidationsschutzschicht nach Anspruch 1, wobei die Schichtdicke jeder Einzelschicht A und/oder B zwischen 50 nm und 100 nm beträgt.

3. Oxidationsschutzschicht nach einem der vorangehenden Ansprüche 1 bis 2, wobei das Verhältnis zwischen der Schichtdicke der Funktionsschicht und der Schichtdicke der Basisschicht zwischen 0.5 und 2 oder zwischen 0.25 und 1.5 ist.

4. Verfahren zur Herstellung einer Oxidationsschutzschicht nach einem der vorhergehenden Ansprüche 1 bis 3, wobei das Verfahren ein Sputter- oder Funkenverdampfungsverfahren ist, und vorzugsweise eine Prozesstemperatur nicht höher als 450 C verwendet wird.

## Claims

1. A chromium-based oxidation protection layer for substrates which are exposed to high temperatures, wherein the chromium-based layer is applied to a substrate by means of PVD and / or CVD and comprises a layer system containing chromium which comprises a base layer and a functional layer, wherein the base layer is between the substrate and the functional layer, wherein the functional layer contains chromium oxide, wherein the functional layer has a multilayer structure including alternatingly deposited individual layers A and B, wherein the composition of the individual layers A differs from the composition of the individual layers B, wherein the base layer consists of chromium nitride, and wherein the individual layers A consist of chromium nitride and the individual layers B consist of chromium oxide or chromium oxynitride,
**characterized in that**, between each individual layer A and each individual layer B which are alternatingly deposited one on top of the other, the multilayer structure comprises an individual layer C whose nitrogen content is greater than the nitrogen content in the directly adjacent individual layer B and less than the nitrogen content in the directly adjacent individual layer A.

2. The oxidation protection layer according to claim 1, wherein the layer thickness of each individual layer A and / or B is between 50 nm and 100 nm.

3. The oxidation protection layer according to one of the preceding claims 1 to 2, wherein the ratio between the layer thickness of the functional layer and the layer thickness of the base layer is between 0.5 and 2 or between 0.25 and 1.5.

4. A method for producing an oxidation protection layer according to one of the preceding claims 1 to 3, wherein the method is a sputtering or spark evaporation method, and preferably a process temperature not higher than 450 ° C is used.

## Revendications

1. Couche de protection contre l'oxydation à base de chrome pour des substrats exposés à des températures élevées, la couche à base de chrome étant appliquée sur un substrat au moyen de PVD et / ou CVD et comprenant un système de couches contenant du chrome, ledit système de couche comprenant une couche de base et une couche fonctionnelle, la couche de base étant entre le substrat et la couche fonctionnelle, la couche fonctionnelle contenant de l'oxyde de chrome, la couche fonctionnelle ayant une structure multicouche comprenant des couches individuelles A et B qui sont déposées en alternance, la composition des couches individuelles A différant de la composition des couches individuelles B, la couche de base étant composée de nitrure de chrome, et les couches individuelles A étant constituées de nitrure de chrome et les couches individuelles B étant constituées d'oxyde de chrome ou d'oxynitrure de chrome,
**caractérisée en ce que**, entre chaque couche individuelle A et chaque couche individuelle B, qui sont déposées l'une sur l'autre en alternance, la structure multicouche comprend une couche individuelle C dont la teneur en azote est supérieure à la teneur en azote contenu dans la couche individuelle B directement adjacente et inférieure à la teneur en azote contenu dans la couche individuelle A directement adjacente.

2. Couche de protection contre l'oxydation selon la revendication 1, l'épaisseur de chaque couche individuelle A et/ou B étant comprise entre 50 nm et 100 nm.

3. Couche de protection contre l'oxydation selon l'une des revendications précédentes 1 à 2, le rapport entre l'épaisseur de la couche fonctionnelle et l'épaisseur de la couche de base étant compris entre 0,5 et 2 ou entre 0,25 et 1,5.

4. Procédé de production d'une couche de protection contre l'oxydation selon l'une quelconque des revendications précédentes 1 à 3, le procédé étant un procédé de pulvérisation ou de vaporisation par étincelle, et de préférence une température de procédé non supérieure à 450 ° C est utilisée.
